# EUROPEAN PATENT SPECIFICATION

(11) **EP 0 366 396 B1**
(45) Date of publication and mention of the grant of the patent: **15.06.1994**
(21) Application number: 89310918.1
(22) Date of filing: 24.10.1989
(51) Int. Cl.: H01L 39/12, H01L 39/14

(54) **Superconductive magneto-resistive device comprising laminated superconductive ceramic films**
Supraleitende magneto-resistive Einrichtung mit laminierten supraleitenden keramischen Filmen
Dispositif magnéto-résistif supraconducteur comportant des films laminés surpaconducteurs en céramique

(30) Priority: 24.10.1988 JP 268586/88
(43) Date of publication of application: 02.05.1990
(73) Proprietor: SHARP KABUSHIKI KAISHA, Osaka 545 (JP)
(72) Inventor: Ohno, Eizo 37-305, Heijyo dai-2-danchi, Nara-shi Nara (JP); Nojima, Hideo 203, Wakakusa-Haitsu, Nara-shi Nara (JP); Nagata, Masaya, Nara-shi Nara (JP); Tsuchimoto, Shuhei, Kitakatsuragi-gun Nara (JP)
(74) Representative: Brown, Kenneth Richard

(56) References cited:
- WO-A-89/05044
- IEEE TRANSACTIONS ON MAGNETICS, vol. 25, no. 2, March 1989, pages 954-956, IEEE, New York, US, & APPLIED SUPERCONDUCTIVITY CONFERENCE, San Francisco, 21st - 25th August 1988; G.K.G. HOHENWARTER et al.: "Single superconducting thin film devices for applications in high Tc materials circuits"
- JAPANESE JOURNAL OF APPLIED PHYSICS, vol. 27, no. 5, May 1988, pages 746-750, Tokyo, JP; H. NOJIMA et al.: "Galvanomagnetic effect of an Y-Ba-Cu-O ceramic superconductor and its application to magnetic sensors"
- JOURNAL OF PHYSICS E- SCIENTIFIC INSTRUMENTS, vol. 19, no. 7, July 1986, pages 502-515, The Institute of Physics, Bristol, GB; W. KWIATKOWSKI et al.: "The permalloy magnetoresistive sensors-properties and applications"
- PROCEEDINGS OF THE INTERNATIONAL ELECTRON DEVICES MEETING, San Francisco, CA, 11th - 14th December 1988, pages 892-893; H. NOJIMA et al.: "Improvement in sensitivity of novel magnetic sensor using Y-Ba-Cu-O ceramic superconductor film"

## Description

### BACKGROUND OF THE INVENTION

### FIELD OF THE INVENTION

The present invention relates to a superconductive magneto-resistive device, and more particularly, to a superconductive magneto-resistive device comprising laminated superconductive ceramic films.

### DESCRIPTION OF RELATED ART

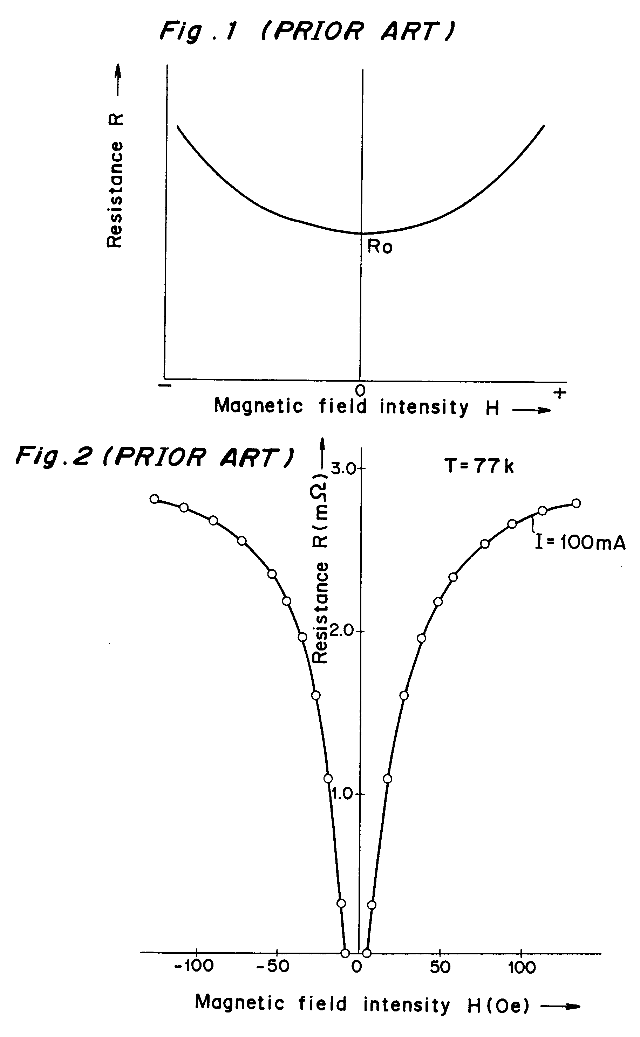

Conventionally, a magnetic sensor utilizing a magneto-resistive device of a semiconductor or a magnetic material has been widely used for measuring a magnetic field. In this sort of magnetic sensor, a device utilizing a form effect such as a semiconductor of InSb, InAs etc. having a high electron mobility and a device utilizing an orientation effect such as a ferromagnetic material of Fe-Ni (permalloy), Co-Ni etc. have been put to practical use. In the conventional magnetic sensor utilizing the magneto-resistive device, the resistance R of the magneto-resistive device increases along a parabolic curve as shown in Fig. 1 when a magnetic field intensity H to be measured is changed in such a state that a constant current I is supplied thereto. Therefore, when the magnetic field intensity H is relatively low, the precision upon measuring a relatively low magnetic field intensity H is lowered since the variation ratio of the resistance to the magnetic field intensity is relatively small.

Further, the SQUID (Superconductive Quantum Interference Device) has been used as a magnetic sensor. The SQUID has an extremely high sensitivity to measure a low magnetic field of about 10⁻¹⁴ T (10⁻¹⁰ gauss), and utilizes the Josephson device wherein an extremely thin insulation film is arranged between superconductive films. However, there are such disadvantages that it is difficult to make the Josephson device since it is made by using a high technique and it is necessary to amplify a voltage generated therein since the level of the output voltage is relatively low.

Furthermore, a magnetic sensor utilizing a magneto-resistive device of superconductive ceramic films comprising grain boundaries has been proposed by the present inventors. In this sort of magnetic sensor, there is used either a superconductive ceramic film comprising grain boundaries in which either an insulation film where grain boundaries of a superconductor are extremely close to each other or a normal conductive film is arranged, or a superconductive ceramic film comprising grain boundaries which are supposed to form point type weak couplings. Even though a relatively low magnetic field is applied to the ceramic superconductor, some of the superconductive state of the above grain boundaries are broken, resulting in that the ceramic superconductor changes to normal conductive phase from the superconductive phase, and the ceramic superconductor has an electrical resistance.

Fig. 2 shows a magneto-resistive characteristic of the above magnetic sensor utilizing the above ceramic superconductor having weak couplings between the grain boundaries, the ceramic superconductor being made by a conventional method for sintering powders of the materials thereof.

An shown in Fig. 2, when a relatively low magnetic field is applied to the ceramic superconductor, some of the above weak couplings between the grain boundaries at the superconductive state are broken, and the resistance thereof increases steeply according to the increase of the magnetic field intensity. This implies that the magnetic sensor utilizing the ceramic superconductor has a high sensitivity even though a relatively low magnetic field is applied thereto. For further discussion of this type of magnetic sensor, please refer to Japanese Journal of Applied Physics, Vol. 27, No. 5, May 1988, pp. 746-750: "Galvano-magnetic Effect of an Y-Ba-Cu-O Ceramic Superconductor and its Application to Magnetic Sensors", H. Nojima et al.

### SUMMARY OF THE INVENTION

An essential object of the present invention is to provide a superconductive magneto-resistive device having a high sensitivity for measuring a relatively low magnetic field.

In order to accomplish the above object, according to the present invention, there is provided a superconductive magneto-resistive device which includes a superconductive ceramic element comprising a plurality of superconductive ceramic films stacked with interleaved electrical insulation films, each intermediate superconductive film being connected to its neighbouring said superconductive films in the stack at respective opposite end portions thereof so that said element forms a convoluted zig-zag current path between electrodes connected to the outermost said superconductive films.

### BRIEF DESCRIPTION OF THE DRAWINGS

These and other objects and features of the present invention will become clear from the following description of a preferred embodiment thereof with reference to the accompanying drawings, in which:
Fig. 1 is a graph showing a magnetic field detection characteristic of a conventional magnetic sensor utilizing a magneto-resistive device;
Fig. 2 is a graph showing a magnetic field detection characteristic of a conventional magnetic sensor utilizing a superconductive magneto-resistive device which is made by a method for sintering powders of compounds of a superconductor so as to form a superconductive element to be used for a magnetic sensor;
Fig. 3 is a schematic view showing a spray pyrolysis method for forming a superconductive ceramic film to be used for a magnetic sensor of a preferred embodiment according to the present invention;
Figs. 4a to 4e are cross sectional views showing a process for making a superconductive magneto-resistive device having a lamination structure of the present preferred embodiment;
Fig. 5 is a perspective view showing a magnetic sensor utilizing a superconductive magneto-resistive device having a lamination structure of the present preferred embodiment according to the present invention;
Fig. 6 is a graph showing a magnetic field detection characteristic of the magnetic sensor shown in Fig. 5;
Fig. 7 is a graph showing a magnetic field detection characteristic of a magnetic sensor of a comparative example; and
Fig. 8 is a perspective view of a superconductive ceramic film of a modification which is shaped into a zigzag configuration.

### DETAILED DESCRIPTION OF THE PREFERRED EMBODIMENT

A preferred embodiment according to the present invention will be described below with reference to the attached drawings.

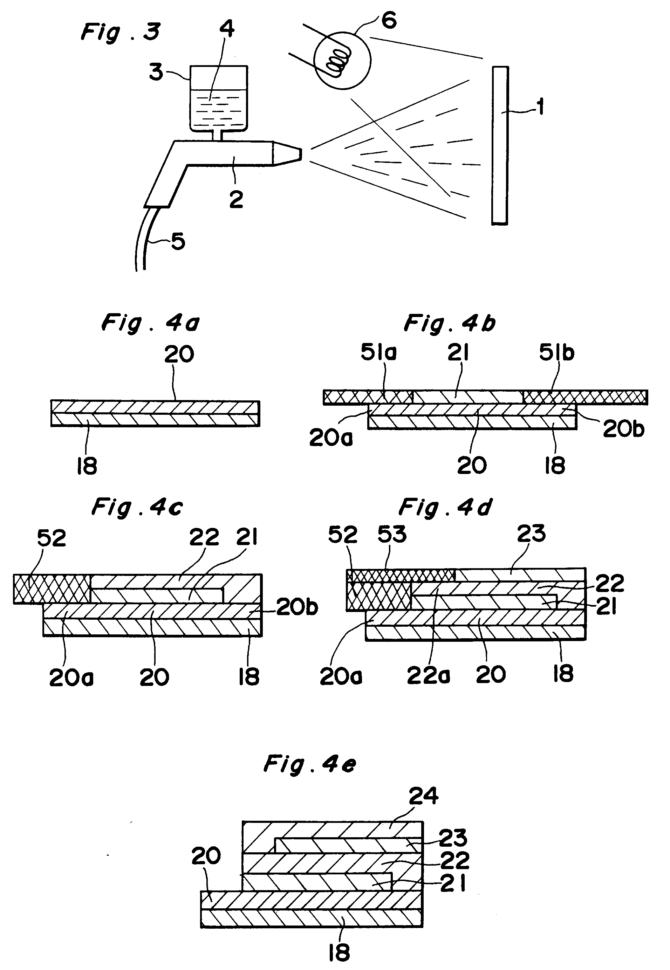

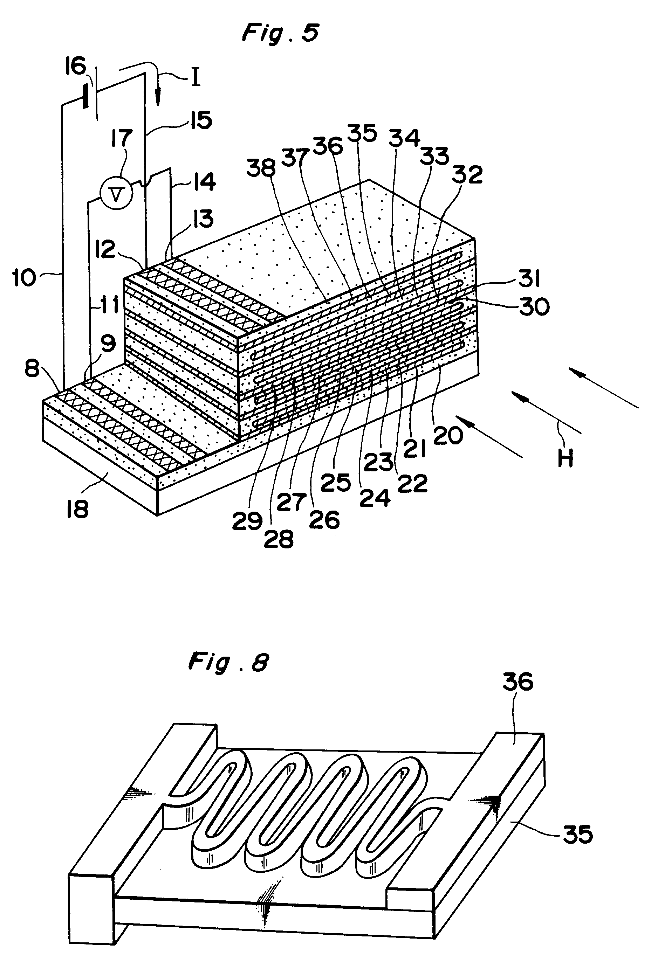

Fig. 5 shows a magnetic sensor using a superconductive magneto-resistive film of a preferred embodiment according to the present invention. The superconductive magneto-resistive film of Y-Ba-Cu-O ceramic compounds is made by a spray pyrolysis method as shown in Fig. 3 as follows.

In the present preferred embodiment, materials of Y(NO₃)₃·6H₂O, Ba(NO₃)₂ and Cu(NO₃)₂·3H₂O are used to form the above-mentioned superconductive magneto-resistive film, and materials of Y(NO₃)₃·6H₂O, Ba(NO₃)₂, Cu(NO₃)₂·3H₂O and Zn(NO₃)·6H₂O are used to form an electrical insulation film.

Powders of Y(NO₃)₃·6H₂O, Ba(NO₃)₂ and Cu(NO₃)₂·3H₂O are weighed at a predetermined ratio. Each powder is sufficiently dissolved into pure water so as to prepare an aqueous solution 4 containing Y, Ba, Cu nitrates. The aqueous solution 4 made as described above is put into a container 3 of a spray gun 2, and is sprayed over a stabilized zirconia substrate 1 which is heated by a heating lamp 6, with use of the spray gun 2 using compressed air 5, with sufficient stirring so as to form a superconductive ceramic film on the substrate 1 in a well known decomposition and oxidation process of the aqueous solution 4.

Similarly, an electrical insulation film is formed thereon by using powders of Y(NO₃)₃·6H₂O, Ba(NO₃)₂, Cu(NO₃)₂·3H₂O and Zn(NO₃)·6H₂O.

Figs. 4a to 4e show a process for making superconductive films having a lamination structure to be used for a magnetic sensor.

First of all, after powders of Y(NO₃)₃·6H₂O, Ba(NO₃)₂ and Cu(NO₃)₂·3H₂O are weighed so that a composition ratio of Y, Ba and Cu becomes 1 : 2 : 3. Each powder is sufficiently dissolved into pure water so as to prepare a first aqueous solution containing Y, Ba, Cu nitrates. The first aqueous solution made as described above is sprayed over a stabilized zirconia substrate 18 having a width of 5 mm and a length of 20 mm which is heated at a temperature in the range from 300°C to 600°C, and thereafter, it is heated at a temperature in the range from 900°C to 1000°C in air at 1.01 x10⁵ Nm⁻²(one atmospheric pressure) so as to form a superconductive ceramic film 20 of Y₁Ba₂Cu₃O_{y} (6.8 ≦ y ≦ 7.0) on the substrate 18 as shown in Fig. 4a.

After powders of Y(NO₃)₃·6H₂O, Ba(NO₃)₂, Cu(NO₃)₂·3H₂O and Zn(NO₃)·6H₂O are weighed so that a composition ratio of Y, Ba, Cu and Zn becomes 1 : 2 : 2.5 : 0.5, each powder is sufficiently dissolved into pure water so as to prepare a second aqueous solution containing Y, Ba, Cu, Zn nitrates. The second aqueous solution is sprayed over the top surface of the superconductive ceramic film 20 by the above spray pyrolysis method in such a state that the right and left side portions 20a and 20b of the film 20 are covered by mask films 51a and 51b, respectively, as shown in Fig. 4b, so as to form an electrical insulation film 21 of Y₁Ba₂Cu_{2.5}Zn_{0.5}O_{y} (6.8 ≦ y ≦ 7.0) having an electrical resistance of several MΩ or more thereon except for the right and left side portions 20a and 20b of the film 20.

After removing the mask films 51a and 51b, the first aqueous solution which is made as described above is sprayed over the top surface of the insulation film 21 and the top surface of the right side portion 20b of the superconductive ceramic film 20 by the above spray pyrolysis method in such a state that the left side portion 20a of the superconductive ceramic film 20 is covered by a mask film 52, as shown in Fig. 4c, so as to form a superconductive ceramic film 22 thereon except for the left side portion 20a of the film 20. Thereafter, the second aqueous solution which is made as described above is sprayed over the top surface of the superconductive ceramic film 22 by the above spray pyrolysis method in such a state that the left side portion 22a of the superconductive ceramic film 22 is covered by a mask film 53, as shown in Fig. 4d, so as to form an insulation film 23 thereon except for the left side portion 22a of the film 22. After removing the mask film 53, as shown in Fig. 4e, a superconductive ceramic film 24 is formed in the manner similar to that of the process for making the superconductive ceramic film 22 shown in Fig. 4c. Similarly, the process for forming the superconductive ceramic film and the insulation film is repeated so as to form the superconductive ceramic films having a lamination structure to be used for the magnetic sensor shown in Fig. 5.

In the structure of the magnetic sensor, ten superconductive ceramic films 20, 22, 24, 26, 28, 30, 32, 34, 36 and 38 are laminated one by one, and nine electrical insulation films 21, 23, 25, 27, 29, 31, 33, 35 and 37 are formed between the adjacent superconductive ceramic films so as to insulate them except for one end portion of each. The insulation film for insulating the upper pair of the adjacent superconductive ceramic films is formed so as to extend in a direction opposite to that of the lower pair of the adjacent films, resulting in that a folded current path is formed in the magnetic sensor shown in Fig. 5.

Furthermore, respective superconductive ceramic films 20, 22, 24, 26, 28, 30, 32, 34, 36 and 38 which have been made in the above process are electrically connected in series to each other. The lattice constant of each superconductive ceramic film is substantially same as that of each insulation film, and the thermal expansion coefficient of each superconductive ceramic film is substantially same as that of each insulation film. Therefore, in the magnetic sensor, any defect due to the mismatching between the lattice does not occur and any peel between the films does not occur, resulting in that there is obtained the superconductive ceramic films having a lamination structure of a good quality to be used for the magnetic sensor.

On the lower-most and upper-most films 20 and 38, a pair of current electrodes 8 and 12 of Ti and a pair of voltage electrodes 9 and 13 of Ti are formed by the vapour deposition method, respectively. The pair of current electrodes 8 and 12 is connected to a constant-current regulated power source 16 for supplying a constant current I through lead wires 10 and 15 bonded thereon with use of Ag paste. The pair of voltage electrodes 9 and 13 is connected to a voltmeter 17 for measuring a voltage generated in the magnetic sensor through lead wires 11 and 14 bonded thereon with use of Ag paste.

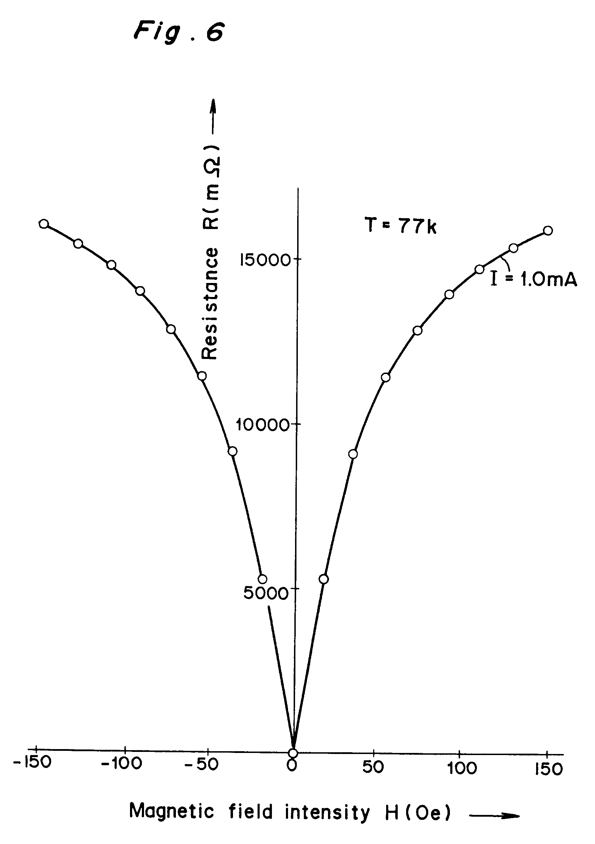

Fig. 6 is a graph showing the result obtained by measurement with use of the magnetic sensor having the ten laminated superconductive ceramic films shown in Fig. 5, which is immersed in liquid nitrogen so as to be cooled at 77K. The thickness of each superconductive ceramic film is 10 »m , and a current of 1 mA is supplied to the magnetic sensor.

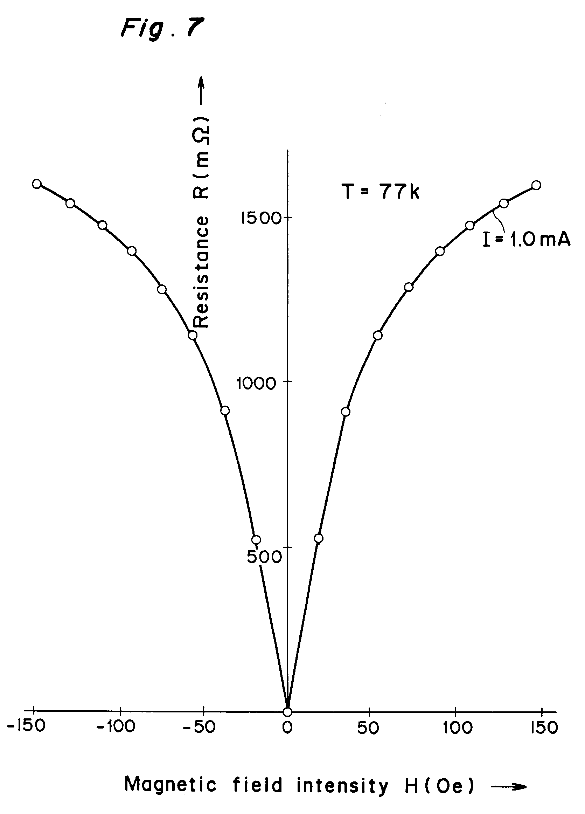

Fig. 7 is a graph showing the result obtained by measurement with use of a magnetic sensor of a comparative example having one superconductive ceramic film which is made in the manner similar to that of the magnetic sensor of the present preferred embodiment shown in Fig. 5. The thickness of the superconductive ceramic film of the magnetic sensor of the comparative example is 10 »m , and a current of 1 mA is supplied thereto.

As is apparent from the comparison between Figs. 6 and 7, when a magnetic filed of 7958 A/m (100 Oe) is applied in parallel to the plane of the superconductive ceramic film or films of each magnetic sensor, in the magnetic sensor of the preferred embodiment, a voltage of about 14 mV is generated when a measuring current of 1 mA is supplied thereto, and then, the resistance thereof is 14 Ω. On the other hand, in the magnetic sensor of the comparative example, as shown in Fig. 7, a voltage of 1.4 mV is generated when a measuring current of 1 mA is supplied thereto, and then, the resistance thereof is 1.4 Ω.

As described above, the magnetic sensor of the preferred embodiment according to the present invention generates ten times the voltage generated by the magnetic sensor of the comparative example having only one superconductive ceramic film, resulting in that a magnetic sensor having a high sensitivity is obtained.

In the present preferred embodiment, the superconductive ceramic films of Y₁Ba₂Cu₃O_{y} (6.8 ≦ y ≦ 7.0) and the electrical insulation films of Y₁Ba₂Cu_{2.5}Zn_{0.5}O_{y} (6.8 ≦ y ≦ 7.0) are used. However, superconductive ceramic films of Y₁Ba₂Cu₃O_{y} (6.5 ≦ y ≦ 6.8) and electrical insulation films of Y₁Ba₂Cu_{2.5}Zn_{0.5}O_{y} (6.5 ≦ y ≦ 6.8) may be used. In this case, the threshold temperature of the superconductive ceramic films of Y₁Ba₂Cu₃O_{y} (6.5 ≦ y ≦ 6.8) at which they change from the normal conductive phase to the superconductive phase is smaller than the threshold temperature of the superconductive ceramic films of Y₁Ba₂Cu₃O_{y} (6.8 ≦ y ≦ 7.0).

In the present preferred embodiment, the magnetic sensor having the superconductive ceramic films of Y-Ba-Cu-O compounds is described; however, the present invention is not so limited. Another magnetic sensor having the superconductive ceramic films of compounds such as Bi₂Sr₂Caₙ₋₁CuₙO₂ₙ₊₄ (n = 1, 2, 3), Tℓ₂Ba₂Caₙ₋₁CuₙO₂ₙ₊₄ (n = 1, 2, 3, 4, 5, 6), Tℓ₁Ba₂Caₙ₋₁CuₙO₂ₙ₊₃ (n = 1, 2, 3, 4, 5, 6, 7), which comprise superconductive grain boundaries, can be applied to the present invention.

In the present preferred embodiment, the spray pyrolysis method is used for forming a superconductive ceramic film; however, the present invention is not so limited. The other methods for forming a superconductive ceramic film such as a spattering method, a CVD method may be used.

It is to be noted that a magnetic sensor comprising the superconductive ceramic films respectively having a smaller thickness has a higher sensitivity. However, when the thickness thereof is equal to or smaller than 0.1 »m , a constant magneto-resistive property of the superconductive ceramic film is not obtained because the grains thereof have grown irregularly due to the heating process after forming the superconductive film.

Furthermore, when the thickness of the superconductive ceramic film is equal to or larger than 50 »m , the smoothness of the surface thereof and the sensitivity of the magnetic sensor are lowered because the grains of the superconductor have grown excessively.

In the present preferred embodiment, the insulation film of Y₁Ba₂Cu_{2.5}Zn_{0.5}O_{y} is used for insulating the adjacent superconductive ceramic films; however, the present invention is not so limited. The ratio of composition of elements constituting the ceramic superconductor may be changed so as to form an insulation superconductive ceramic film suitable for making the magnetic sensor comprising the superconductive ceramic films having a lamination structure. For example, as the superconductive films, a material of compounds such as A₁Ba₂Cu₃O_{y} (6.5 ≦ y ≦ 7.0) or A₁Ba₂₋ₓSrₓCu₃O_{y} (0 ≦ x ≦ 0.5, 6.5 ≦ y ≦ 7.0) may be used, wherein the above element A is either Lu, Yb, Tm, Er, Y, Ho, Dy, Gd, Eu, Sm or Nd. On the other hand, as the electrical insulation films, a material of compounds such as Q₁Ba₂Cu₃O_{y} (6.5 ≦ y ≦ 7.0), Q₁Ba₂Cu_{3-z}M_{z}O_{y} (6.5 ≦ y ≦ 7.0, z ≧ 0.5), Q₁Ba₂₋ₓSrₓCu₃O_{y} (x > 0.5, 6.5 ≦ y ≦ 7.0), Q₁Ba₂₋ₓSrₓCu_{3-z}M_{z}O_{y} (x > 0.5, 6.5 ≦ y ≦ 7.0, z ≧ 0.5), Y₁Ba₂Cu_{3-z}M_{z}O_{y} (6.5 ≦ y ≦ 7.0, z ≧ 0.5), Y₁Ba₂₋ₓSrₓCu₃O_{y} (x > 0.5, 6.5 ≦ y ≦ 7.0), Y₁Ba₂₋ₓSrₓCu_{3-z}M_{z}O_{y} (x > 0.5, 6.5 ≦ y ≦ 7.0, z ≧ 0.5) may be used, wherein the above element Q is either Sc, Ce, Pr or Tb, and the above element M is either Fe, Co, Zn, Cr, Ga or Ni.

The shape of the superconductive ceramic film according to the present invention is not limited to that of the present preferred embodiment shown in Fig. 5. For example, each superconductive ceramic film may be shaped into a zigzag configuration as shown in Fig. 8 by using a photolithographic method etc. and an etching method or a masked film deposition method. In this case, the number of the grain boundaries which are in contact in series can be further increased, resulting in that a magnetic sensor having a higher sensitivity can be obtained.

As described above, there can be obtained the magnetic sensor utilizing the magneto-resistive device constituted by the superconductive ceramic films having a lamination structure according to the present invention, which has an extremely high sensitivity and acts at an extremely low consumption power.

It is understood that various other modifications will be apparent to and can be readily made by those skilled in the art without departing from the scope of the present invention as defined by the appended claims.

## Claims

1. A superconductive magneto-resistive device which includes a superconductive ceramic element comprising a plurality of superconductive ceramic films (20,22,24,26, 28,30,32,34,36,38) stacked with interleaved electrical insulation films (21,23,25,27,29,31,33,35,37), each intermediate superconductive film being connected to its neighbouring said superconductive films in the stack at respective opposite end portions thereof so that said element forms a convoluted zig-zag current path between electrodes (8,9;12,13) connected to the outermost said superconductive films (20;38).

2. The superconductive magneto-resistive device as claimed in claim 1, wherein the thickness of each of said superconductive ceramic films is in the range from 0.1 »m to 50 »m.

3. The superconductive magneto-resistive device as claimed in claim 1, wherein said electrical insulation film is made by adding one element to the composition of said superconductive ceramic film.

4. The superconductive magneto-resistive device as claimed in claim 1, wherein said electrical insulation film is made by replacing at least one element of the composition of said superconductive ceramic film as a whole or partially with another element.

5. The superconductive magneto-resistive device as claimed in claim 1, wherein said electrical insulation film is made by changing the ratio of the elements of the composition of said superconductive ceramic film.

6. The superconductive magneto-resistive device as claimed in claim 3, wherein said superconductive ceramic film is made of Y₁Ba₂Cu₃O_{y}, and said electrical insulation film is made of Y₁Ba₂Cu_{2.5}Zn_{0.5}O_{y}.

7. The superconductive magneto-resistive device as claimed in claim 1, wherein said superconductive ceramic film is made of a Bi-Sr-Ca-Cu-O compound.

8. The superconductive magneto-resistive device as claimed in claim 1, wherein said superconductive ceramic film is made of a Tl-Ba-Ca-Cu-O compound.

## Patentansprüche

1. Supraleitende magneto-resistive Einrichtung, die ein supraleitendes keramisches Element mit mehreren supraleitenden keramischen Filmen (20, 22, 24, 26, 28, 30, 32, 34, 36, 38) aufweist, die mit verschachtelten elektrisch isolierenden Filmen (21, 23, 25, 27, 29, 31, 33, 35, 37) übereinandergestapelt sind, wobei jeder supraleitende Zwischenfilm mit seinen benachbarten supraleitenden Filmen im Stapel an jeweils gegenüberliegenden Endabschnitten so verbunden ist, daß das Element einen gewundenen Zickzackstrompfad zwischen den an die äußersten supraleitenden Filme (20; 38) angeschlossenen Elektroden (8, 9; 12, 13) bildet.

2. Supraleitende magneto-resistive Einrichtung nach Anspruch 1, bei der die Dicke jedes der supraleitenden keramischen Filme im Bereich von 0,1 »m bis 50 »m liegt.

3. Supraleitende magneto-resistive Einrichtung nach Anspruch 1, bei der der elektrisch isolierende Film dadurch hergestellt wird, daß ein Element zur Zusammensetzung des supraleitenden keramischen Films hinzugefügt wird.

4. Supraleitende magneto-resistive Einrichtung nach Anspruch 1, bei der der elektrisch isolierende Film dadurch hergestellt wird, daß mindestens ein Element der Zusammensetzung des supraleitenden keramischen Films insgesamt oder teilweise durch ein anderes Element ersetzt wird.

5. Supraleitende magneto-resistive Einrichtung nach Anspruch 1, bei der der elektrisch isolierende Film dadurch hergestellt wird, daß das Verhältnis der Elemente der Zusammensetzung des supraleitenden keramischen Films verändert wird.

6. Supraleitende magneto-resistive Einrichtung nach Anspruch 3, bei der der supraleitende keramische Film aus Y₁Ba₂Cu₃O_{y} besteht und der elektrisch isolierende Film aus Y₁Ba₂Cu_{2,5}Zn_{0,5}O_{y} besteht.

7. Supraleitende magneto-resistive Einrichtung nach Anspruch 1, bei der der supraleitende keramische Film aus einer Bi-Sr-Ca-Cu-O-Verbindung besteht.

8. Supraleitende magneto-resistive Einrichtung nach Anspruch 1, bei der der supraleitende keramische Film aus einer Tl-Ba-Ca-Cu-O-Verbindung besteht.

## Revendications

1. Dispositif magnéto-résistif supraconducteur, qui comprend un élément céramique supraconducteur composé d'une pluralité de couches céramiques supraconductrices (20, 22, 24, 26, 28, 30, 32, 34, 36, 38) empilées avec imbrication de couches électriquement isolantes (21, 23, 25, 27, 29, 31, 33, 35, 37), chaque couche supraconductrice intermédiaire étant reliée à ses dites couches supraconductrices voisines dans l'empilement au niveau de leurs parties extrémités opposées respectives, de telle manière que ledit élément forme un chemin de convolution en zigzag pour le courant entre des électrodes (8,9 ; 12, 13) reliées auxdites couches supraconductrices situées le plus à l'extérieur (20;38).

2. Dispositif magnéto-résistif supraconducteur selon la revendication 1, dans lequel l'épaisseur de chacune desdites couches céramiques supraconductrices est située dans la plage de 0,1 »m à 50 »m.

3. Dispositif magnéto-résistif supraconducteur selon la revendication 1, dans lequel ladite couche électriquement isolante est obtenue en ajoutant un élément à la composition de ladite couche céramique supraconductrice.

4. Dispositif magnéto-résistif supraconducteur selon la revendication 1, dans lequel ladite couche électriquement isolante est obtenue en remplaçant au moins un élément de la composition de ladite couche céramique supraconductrice, en totalité ou en partie, par un autre élément.

5. Dispositif magnéto-résistif supraconducteur selon la revendication 1, dans lequel ladite couche électriquement isolante est obtenue en modifiant le rapport des éléments de la composition de ladite couche céramique supraconductrice.

6. Dispositif magnéto-résistif supraconducteur selon la revendication 3, dans lequel ladite couche céramique supraconductrice est faite en Y₁Ba₂Cu₃O_{y}, et ladite couche électriquement isolante est faite en Y₁Ba₂Cu_{2,5}Zn_{0,5}O_{y}.

7. Dispositif magnéto-résistif supraconducteur selon la revendication 1, dans lequel ladite couche céramique supraconductrice est faite d'un composé de Bi-Sr-Ca-Cu-O.

8. Dispositif magnéto-résistif supraconducteur selon la revendication 1, dans lequel ladite couche céramique supraconductrice est faite d'un composé de Tl-Ba-Ca-Cu-O.
